# EUROPÄISCHE PATENTSCHRIFT

(11) **EP 0 895 362 B1**
(45) Veröffentlichungstag und Bekanntmachung des Hinweises auf die Patenterteilung: **18.08.2004**
(21) Anmeldenummer: 98113674.0
(22) Anmeldetag: 22.07.1998
(51) Int. Cl.: H03M 11/24

(54) **Elektrische Schaltungsanordnung zur Erfassung eines Schaltzustands**
Electrical circuit for the detection of the state of a switching arrangement
Circuit électrique pour la détection de l'état d'un dispositif de commutation

(30) Priorität: 26.07.1997 DE 19732283
(43) Veröffentlichungstag der Anmeldung: 03.02.1999
(73) Patentinhaber: Leopold Kostal GmbH & Co. KG, 58507 Lüdenscheid (DE)
(72) Erfinder: Lampe, Wolfgang, 58809 Neuenrade (DE)

(56) Entgegenhaltungen:
- FR-A- 2 653 279
- US-A- 4 234 872
- US-A- 4 471 234
- PATENT ABSTRACTS OF JAPAN vol. 010, no. 039 (E-381), 15. Februar 1986 & JP 60 194697 A (HITACHI SEISAKUSHO KK), 3. Oktober 1985

## Beschreibung

Die vorliegende Erfindung geht von einer gemäß dem Oberbegriff des Hauptanspruches konzipierten elektrischen Schaltungsanordnung aus.

Eine derartige - an einer Gleichspannungs-Versorgung liegende - Schaltungsanordnung ist dafür vorgesehen, um über derselben zugehörige Schaltvorrichtungen damit kooperierende Verbraucher leistungslos ein- und auszuschalten. Dabei wird über die Schaltvorrichtungen lediglich ein Signalstrom geführt, mit dem den Verbrauchern zugeordnete Leistungstreiber, wie z.B. Relais oder Leistungshalbleiter, angesteuert werden.

Um bei mehreren einer Schaltungsanordnung zugehörigen Schaltvorrichtungen nicht jede Schaltvorrichtung über eine eigene elektrische Leitung mit ihrem Leistungstreiber zu verbinden, ist es bekannt, diese jeweils mit einem Widerstand zu versehen, wobei die Widerstände in ihrem Widerstandswert sich unterscheiden, so daß einer den Leistungstreibern der Verbraucher zugeordneten Auswert-Elektronik Steuersignale vermittelt werden, die sich im Sinne einer Spannungskodierung auf unterschiedlichem Niveau bewegen.

Problematisch bei diesem an und für sich sehr zuverlässigen Funktionsprinzip ist, daß bei einer Vielzahl von Schaltvorrichtungen die den Schaltvorrichtungen zugehörigen Spannungspegel bzw. die daraus resultierenden Ströme in ihrer Stufung sich nicht mehr derart unterscheiden, daß insbesondere bei mehreren gleichzeitig betriebenen Schaltvorrichtungen eine sichere Erfassung und Zuordnung dieser Schaltvorrichtungen bzw. einer einzelnen Schaltvorrichtung durch die Auswert-Elektronik gewährleistet ist.

In dieser Hinsicht ist durch die FR 2 653 279 A1 eine an einer Gleichspannungs-Versorgung angeschlossene elektrische Schaltungsanordnung bekanntgeworden, bei der mehrere mit jeweils einem vorgeschalteten Widerstand versehene, in zwei Gruppen unterteilte Schaltvorrichtungen vorhanden sind, die mit zwei Anschlüssen einer Auswertelektronik über zwei Dioden derart verbunden ist, daß die beiden Schaltvorrichtungs-Gruppen alternierend an den beiden Polen der Gleichspannungs-Versorgung liegen, wobei die beiden Anschlüsse der Auswert-Eiektronik mit einem von den eingeschalteten Schaltvorrichtungen bzw. den zugehörigen Widerständen abhängigen Signalwert behaftet sind.

Darüber hinaus ist durch JP 60 194 697 A eine elektrische Schaltungsanordnung bekannt geworden, bei der mehrere mit vorgeschalteten Widerständen versehene, ebenfalls in zwei Gruppen aufgeteilte Schaltvorrichtungen vorhanden sind, die mit zwei Anschlüssen einer zwei Meßwiderstände aufweisenden Auswertelektronik über zwei Dioden verbunden sind, wobei die beiden Anschlüsse mit einem von den eingeschalteten Schaltvorrichtungen bzw. den zugehörigen Widerständen abhängigen Meßstrom (Signalwert) behaftet sind.

Der vorliegenden Erfindung liegt die Aufgabe zugrunde, eine Schaltungsanordnung der vorerwähnten Art derart weiterzubilden, daß denselben auf einfache Art und Weise, d.h., mit einem äußerst geringem Aufwand eine Suchbeleuchtung zuordenbar ist.

Erfindungsgemäß wird die Aufgabe durch die im kennzeichnenden Teil des Hauptanspruches angegebenen Merkmale gelöst.
Vorteilhaft bei einem solchen Aufbau einer Schaltungsanordnung ist, daß nur unter Hinzufügung einer einzigen elektrischen Verbindungsleitung eine ständig funktionsbereite Suchbeleuchtung realisierbar ist.

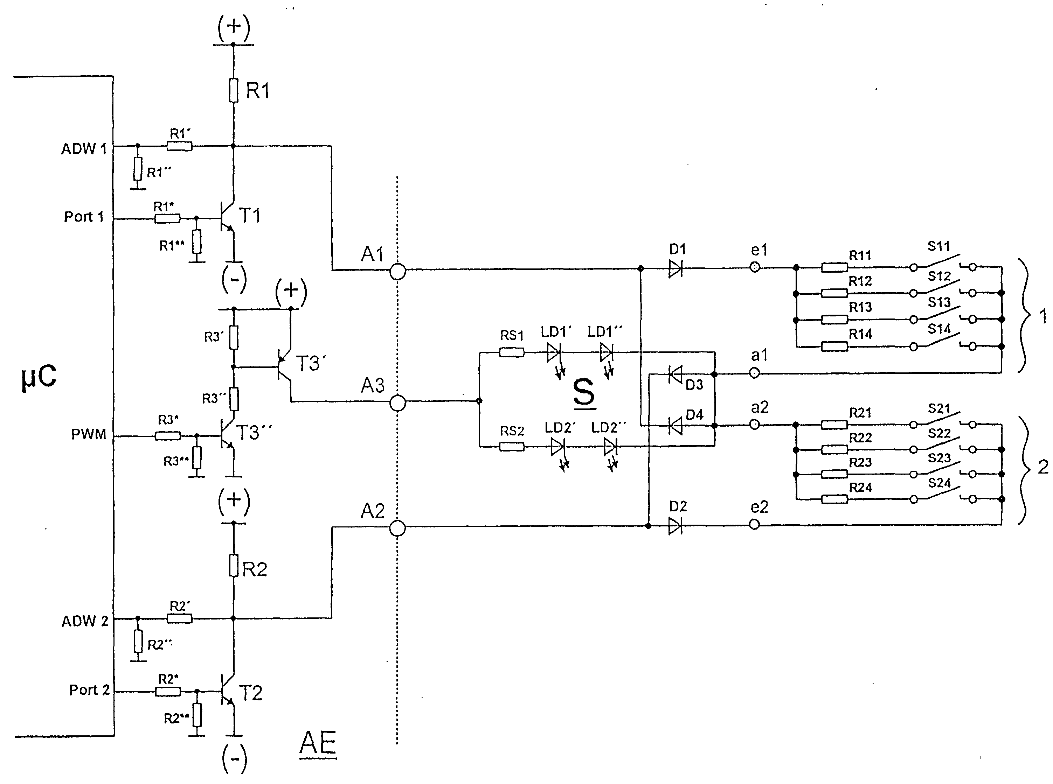

Weitere besonders günstige Ausgestaltungen des erfindungsgemäßen Gegenstandes sind in den Unteransprüchen angegeben und werden anhand eines in der Zeichnung dargestellten Ausführungsbeispieles näher erläutert.

Wie aus der Zeichnung hervorgeht, ist eine an einer Gleichspannungs-Versorgung liegende Auswert-Elektronik AE einerseits über ihre Anschlüsse A1,A2 mit einer Vielzahl von in zwei Schaltvorrichtungs-Gruppen 1,2 aufgeteilten, vorzugsweise parallel geschalteten Schaltvorrichtungen S11-S14, S21-S24 verbunden. Den vorzugsweise zu betätigenden Schaltvorrichtungen ist jeweils ein Widerstand R11-R14, R21-R24 zugeordnet. Die Widerstände sind in ihrem jeweiligen Wert derart unterschiedlich gewählt, daß auch bei mehreren gleichzeitig betätigten Schaltvorrichtungen sich nur Ströme in den Anschlußleitungen ergeben, die eindeutig von der Auswert-Elektronik identifizierbar sind.

Damit eine eindeutige Erfassung der mit den beiden Schaltvorrichtungs-Gruppen zusammenhängenden Verhältnisse verwirklichter ist, sind die beiden Eingänge e1 ,e2 der beiden Schaltvorrichtungs-Gruppen 1,2 über jeweils eine in Durchlaßrichtung angeordnete Diode D1,D2 mit den Anschlüssen A1,A2 verbunden und die beiden Ausgänge a1,a2 jeweils an dem dem Eingang der jeweils anderen Schaltvorrichtungs-Gruppe zugeordneten Anschluß A1,A2 gelegt, so daß die beiden Schaltvorrichtungs-Gruppen alternierend über jeweils einen Meßwiderstand R1,R2 mit dem positiven Pol (+) und über zwei NPN-Transistoren T1, T2 mit dem negativen Pol (-) der Gleichspannungs-Versorgung verbindbar sind.

Außerdem ist jeder dieser Anschlüsse A1,A2 einerseits über eine Widerstandsanordnung R1',R1'';R2',R2'' mit jeweils einem Analog/Digital-Wandler-Eingang ADW1,ADW2 eines Mikrocomputers µC verbunden und andererseits am Emitter von jeweils einem NPN-Transistor T1,T2 angeschlossen, von denen jeweils der Kollektor am negativen Pol (-) der Gleichspannungs-Versorgung liegt und deren jeweilige Basis über eine Widerstandsanordnung R1,*,R1**; R2*,R2** mit jeweils einem Ausgang Port1,Port 2 des Mikrocomputers verbunden ist.

Die vorgenannten, jeweils aus zwei im Sinne eines Spannungsteilers fungierenden Widerständen bestehenden Widerstandsanordnungen - wie z.B. R1',R1" - sind nur bei einer relativ hohen Gleichspannungs-Versorgung, beispielsweise bei 12V, erforderlich. Bei einer deutlich geringeren Größenordnung, beispielsweise bei 5V, reicht jeweils ein Widerstand in den Verbindungsleitungen der Ein- und Ausgänge des Mikrocomputers vollkommen aus.

Im Zusammenhang mit Schaltungsanordnungen der betreffenden Art ist es erwünscht, den Schaltvorrichtungs-Gruppen 1,2 eine Suchbeleuchtung (S) zuzuordnen. Dabei wird diese vorteilhafterweise aus zwei Schaltzweigen gebildet, wobei in jedem Schaltzweig eine aus zumindest einer Leuchtdiode bestehende Lichtquelle vorhanden ist. Nach dem Ausführungsbeispiel sind an einem dritten Anschluß A3 der Auswert-Elektronik AE einerseits pro Schaltzweig über jeweils einen Vorwiderstand RS1, RS2 jeweils zwei Leuchtdioden LD1';LD1''; LD2',LD2'' angeschlossen, die andererseits mit den Ausgängen a1,a2 der beiden Schaltvorrichtungs-Gruppen 1,2 verbunden sind. Zudem sind die Ausgänge a1,a2 über je eine in Sperrichtung geschaltete Diode D3,D4 jeweils mit dem dem einen Anschlußknoten der anderen Schaltvorrichtungs-Gruppe zugehörigen Anschluß A2,A1 verbunden. Zur Ansteuerung der Suchbeleuchtung S ist der Anschluß A3 mit dem Kollektor eines mit seinem Emitter am positiven Pol der Gleichspannungs-Versorgung liegenden PNP-Transistors T3' verbunden, dessen Basis mit dem Teilerpunkt eines einerseits am positiven Pol der Gleichspannungs-Versorgung liegenden und andererseits mit dem Emitter eines mit seinem Kollektor am negativen Pol angeschlossenen NPN-Transistors T3" verbundenen Spannungsteilers R3', R3" angeschlossen ist, dessen Basis über eine Widerstandsanordnung R3*,R3** an einem ein pulsweitenmoduliertes Signal liefernden Eingang PWM des Mikrocomputers liegt.

Ist für die Suchbeleuchtung nur ein relativ niedrige Gleichspannungs-Versorgung - wie z.B. 5V - erforderlich, so reicht für die über den PWM-Ausgang erfolgende Beeinflussung derselben auch ein PNP- oder NPN-Transistor in entsprechender Anordnung vollkommen aus.

Im Falle eines auf kundenspezifische Belange zugeschnittenen Bausteins (ASIC) werden die zur Auswert-Elektronik AE gehörenden Bauelemente, d.h. die zuvor beschriebenen Transistoren und Widerstände in den Mikrocomputer integriert.

Nachfolgend wird die Funktion der vorbeschriebenen Schaltungsanordnung näher verdeutlicht.

Im passiven Zustand des elektrischen Systems ist lediglich die Suchbeleuchtung in Funktion und zwar, um einem Benutzer der Schaltungsanordnung ein Auffinden der einzelnen Schaltvorrichtungen zu erleichtern. Dabei ist durch Ansteuerung der Basis des Transistors T3'' der Transistor T3' durchgeschaltet, so daß an den Leuchtdioden LD1,LD2 einerseits der positive Pol der Gleichspannungs-Versorgung liegt. Andererseits sind dieselben über die Dioden D3 und/oder D4 und über den einen und/oder den anderen Transistor T1,T2 mit dem negativen Pol der Gleichspannungs-Versorgung verbunden, so daß über diese eine Helligkeit vermittelt wird, die in Abhängigkeit des pulsweitenmodulierten Ausgangssignals des Mikrocomputers steht. Die Helligkeit der Suchbeleuchtung kann aber auch durch die Einschaltdauer der Transistoren T1,T2 beeinflußt werden, wobei dann der Anschluß A3 in der Auswert-Elektronik AE direkt auf den positiven Pol (+) geschaltet werden kann.

In bestimmten Zeitintervallen, z.B. alle 10 Millisekunden, wird dann das System aktiviert, d.h. die Schaltvorrichtungs-Gruppen 1,2 werden nacheinander bzgl. ihres Schaltzustandes zyklisch abgefragt. Während dieser Abfrage ist die Suchbeleuchtung auf jeden Fall so geschaltet, daß diese über den jeweils mit seinem Kollektor am negativen Pol liegenden - der nicht angesteuerten Schaltvorrichtungs-Gruppe 1,2 zugehörenden - Transistor T2,T1 ebenfalls am negativen Pol liegt.

Bei einer oder mehreren eingeschalteten Schaltvorrichtung(en) einer Schaltvorrichtungs-Gruppe 1,2 fällt an dem zugeordneten Meßwiderstand R1,R2 eine davon abhängige Spannung ab und der zugehörige Analog/Digital-Wandler-Eingang ADW1 oder ADW2 erhält ein entsprechendes Signal, das vom Mikrocomputer erkannt und zur Ansteuerung von der bzw. den Schaltvorrichtung(en) zugehörigen, der Einfachheit halber nicht dargestellten, mit ebenfalls der Einfachheit halber nicht dargestellten Verbrauchern verbundenen Leistungstreibem herangezogen wird. Da dieser Vorgang blockweise in relativ kurzen zeitlichen Abständen erfolgt, ist sichergestellt, daß eine Erfassung von auch nur kurzfristig sich ändernden Schaltzuständen sicher gewährleistet ist.

## Patentansprüche

1. Elektrische, an einer Gleichspannungs-Versorgung angeschlossene Schaltungsanordnung mit mehreren ein- und ausschaltbaren, elektrisch miteinander verbundenen, jeweils einen vorgeschalteten Widerstand (R11-R14, R21-R24) zur spannungscodierten Signalgabe aufweisenden Schaltvorrichtungen (S11-S14; S21-S24), die einer ihre jeweiligen Schaltzustände durch Strommessung erfassenden Auswert-Elektronik (AE) zugeordnet sind, wobei die Schaltvorrichtungen (S11-S14; S21-S24) in zwei jeweils mehrere Schaltvorrichtungen (S11-S14; S21-S24) aufweisende Schaltvorrichtungs-Gruppen (1, 2) unterteilt sind, wobei die Schaltvorrichtungs-Gruppen (1, 2) über Dioden (D1-D4) mit zwei Anschlüssen (A1, A2) der Auswert-Elektronik (AE) verbunden sind, die jeweils mit einem von den eingeschalteten Schaltvorrichtungen (S11-S14; S21-S24) bzw. den zugehörigen Widerständen (R11-R14; R21-R24) abhängigen, d.h., codierten elektrischen Signalwert behaftet sind und wobei die Schaltvorrichtungs-Gruppen (1, 2) durch die Auswert-Elektronik (AE) alternierend mit den beiden Polen (+, -) der Gleichspannungs-Versorgung verbunden sind,
**dadurch gekennzeichnet,**
- **daß** die Schaltvorrichtungs-Gruppen (1, 2) an ihren Eingängen (e1, e2) und an ihren Ausgängen (a1, a2) jeweils eine Diode (D1, D2, D3, D4) aufweisen, wobei jede Schaltvorrichtungs-Gruppe (1, 2) über jeweils eine Diode (D1, D3 bzw. D2, D4) mit jedem der beiden Anschlüsse (A1, A2) der Auswert-Elektronik (AE) verbunden ist,
- **daß** jeder der beiden Anschlüsse (A1, A2) der Auswert-Elektronik (AE) über jeweils einen Meßwiderstand (R1, R2) am positiven Pol (+) der Gleichspannungs-Versorgung anliegt,
- **daß** zwei gleichsinnig zueinander angeordnete, der einen Schaltvorrichtungs-Gruppe (1) zugehörige Dioden (D1, D3) gegensinnig zu zwei ebenfalls gleichsinnig
- zueinander angeordneten, der anderen Schaltvorrichtungs-Gruppe (2) zugehörigen Dioden (D2, D4) liegen und
- **daß** den beiden Schaltvorrichtungs-Gruppen (1, 2) jeweils eine aus zumindest einer Leuchtdiode (LD1', LD2', LD1", LD2") bestehende Suchbeleuchtung (S) zugeordnet ist, die einerseits mit einem dem positiven Pol (+) der Gleichspannungs-Versorgung zugeordneten dritten Anschluß (A3) der Auswert-Elektronik (AE) verbunden ist und andererseits über die beiden, den miteinander verbundenen Ausgängen (a1, a2) der beiden Schaltvorrichtungs-Gruppen (1, 2) zugeordneten, die Verbindung zum negativen Pol (-) der Gleichspannungs-Versorgung gewährleistenden Dioden (D3, D4) an den beiden Anschlüssen (A1, A2) der Auswert-Elektronik (AE) liegt.

2. Elektrische Schaltungsanordnung nach Anspruch 1, **dadurch gekennzeichnet, daß** die Auswert-Elektronik (AE) einen Mikrocomputer (µC) aufweist, der für jede Schaltvorrichtungs-Gruppe (1;2) einen Steuer-Ausgang (Port1, Port2) und einen Analog/Digital-Wandler-Eingang (ADW1;ADW2) aufweist, daß an jedem der beiden Steuer-Ausgänge über eine-Widerstandsanordnung (R1*,R1**;R2*,R2**) die Basis von jeweils einem Schalttransistor (T1;T2) angeschlossen ist, dessen Kollektor einerseits über den zugehörigen Meßwiderstand (R1;R2) mit dem positiven Pol (+) der Gleichspannungs-Versorgung und andererseits sowohl mit dem zugeordneten Anschluß (A1;A2) der Auswert-Elektronik (AE), als auch über eine weitere Widerstandsanordnung (R1',R1";R2',R2") mit dem Analog/Digital-Wandler-Eingang (ADW1,ADW2) verbunden ist.

3. Elektrische Schaltungsanordnung nach Anspruch 2, **dadurch gekennzeichnet, daß** die beiden Schalttransistoren (T1;T2) und die zugehörigen Widerstandsanordnungen (R1',R1";R2',R2";R1*,R1**;R2*,R2**), als auch die beiden Meßwiderstände (R1;R2) in den Mikrocomputer (µC) integriert sind.

4. Elektrische Schaltungsanordnung nach einem der Ansprüche 1 bis 3, **dadurch gekennzeichnet, daß** der dem positiven Pol (+) zugeordnete, zur Versorgung der Suchbeleuchtung (S) vorgesehene Anschluß (A3) der Auswert-Elektronik (AE) ein pulsweitenmoduliertes Signal dadurch liefert, daß derselbe über einen PNP-Transistor (T3') mit der Gleichspannungs-Versorgung verbunden ist, dessen Basis über einen aus zwei Widerständen (R3',R3") gebildeten Spannungsteiler einerseits mit dem positiven Pol (+) der Gleichspannungsversorgung und andererseits mit dem Kollektor eines mit seinem Emitter an Masse liegenden NPN-Transistors (T3") verbunden ist, dessen Basis wiederum über eine Widerstandskombination (R3*,R3**) an einem ein pulsweitenmoduliertes Signal abgebenden Ausgang (PWM) des Mikrocompters (µC) angeschlossen ist.

5. Elektrische Schaltungsanordnung nach einem der Ansprüche 1 bis 3, **dadurch gekennzeichnet, daß** die Helligkeit der Suchbeleuchtung (S) durch deren Einschaltdauer beeinflußt ist und daß diese Einschaltdauer von der Einschaltdauer der Transistoren (T1 ,T2) abhängig ist.

6. Elektrische Schaltungsanordnung nach einem der Ansprüche 1 bis 5, **dadurch gekennzeichnet, daß** der negative Pol (-) der Gleichspannungs-Versorgung - wie in Kraftfahrzeugen üblich - auf Masse liegt.

## Claims

1. Electrical circuit configuration that is connected to a direct voltage supply and comprises several actuators (S11-S14; S21-S24) which can be switched on and off and are electrically interconnected, each of which features an upstream resistor (R11-R14; R21-R24) for the purpose of transmitting voltage-coded signals and each of which is assigned to an electronic analyzing unit (AE) that detects their respective circuit states by means of current measurement; with the actuators (S1-S14; S21-S24) being divided into two actuator groups (1,2) each comprising several actuators (S11-S14; S21-S24), with the actuator groups (1,2) connected by means of diodes (D1-D4) to two terminals (A1,A2) of the electronic analyzing unit (AE) each of which is loaded with an electrical signal value that is dependent on the switched-on actuators (S11-S14; S21-S24) or associated resistors (R11-R14; R21-R24) respectively, i.e. coded, with the actuator groups (1,2) being alternately connected by way of the electronic analyzing unit (AE) to either of the two poles (+, -) of the direct voltage supply.
**characterized by** the fact
- that the actuator groups (1,2) feature a diode (D1, D2, D3, D4) at each of their inputs (e1, e2) and at each of their outputs (a1, a2), with each actuator group (1, 2) being connected by means of a diode (D1, D3 or D2, D4) to each of the two terminals (A1, A2) of the electronic analyzing unit (AE);
- that each of the two terminals (A1, A2) of the electronic analyzing unit (AE) lies by way of a measuring resistor (R1, R2) at the positive pole (+) of the direct voltage supply;
- that two diodes (D1, D3) arranged equi-directionally to each other and belonging to the one actuator group (1) lie inversely to two diodes (D2, D4) which are likewise arranged equi-directionally to each other and belong to the other actuator group (2), and
- that a locator lamp (S) consisting of at least one light emitting diode (LD1', LD2', LD1", LD2") is assigned to each of the two actuator groups (1, 2) and is connected on the one hand to a third terminal (A3) of the electronic analyzing unit (AE) assigned to the positive pole (+) of the direct voltage supply, and lies on the other hand at the two terminals (A1, A2) of the electronic analyzing unit (AE) by means of the two diodes (D3, D4) that warrant the connection to the negative pole (-) of the direct voltage supply and are assigned to the interconnected outputs (a1, a2) of the two actuator groups (1, 2).

2. Electrical circuit configuration in accordance with Claim 1, **characterized by** the fact that the electronic analyzing unit (AE) features a micro-computer (µc) which features a control output (Port1, Port2) and an analog/digital converter input (ADW1; ADW2) for each actuator group (1, 2); that connected to each of the two control outputs by means of a resistor arrangement (R1*, R1**; R2*, R2**) is the base of a switching transistor (T1; T2) whose collector is connected by means of the appurtenant measuring resistor (R1; R2) to the positive pole (+) of the direct voltage supply on the one hand and both to the assigned terminal (A1, A2) of the electronic analyzing unit (AE) and by means of a further resistor arrangement (R1', R1"; R2', R") to the analog/digital converter input (ADW1; ADW2) on the other hand.

3. Electrical circuit configuration in accordance with Claim 2, **characterized by** the fact that the two switching transistors (T1, T2) and the appurtenant resistor arrangements (R1', R1"; R2', R2"; R1*, R1**; R2*, R2**) as well as the two measuring resistors (R1; R2) are integrated in the micro-computer µC).

4. Electrical circuit configuration in accordance with any of Claims 1 to 3, **characterized by** the fact that the terminal (A3) of the electronic analyzing unit (AE) provided for supplying power to the locator lamp (S) and assigned to the positive pole (+) transmits a pulse width modulated signal as a result of the same being connected to the direct voltage supply by means of a PNP transistor (T3') whose base is connected to the positive pole (+) of the direct voltage supply by means of a voltage divider constituted by two resistors (R3', R3") on the one hand, and on the other hand to the collector of an NPN transistor (T3") whose emitter is connected to ground whose base is, however, connected by way of a combination of resistors (R3*, R3**) to an output emitting a pulse width modulated signal (PWM) of the micro-computer (µC).

5. Electrical circuit configuration in accordance with any of Claims 1 to 3, **characterized by** the fact that the brightness of the locator lamp (S) is influenced by its ON duration and that this ON duration is dependent on the ON duration of the transistors (T1, T2).

6. Electrical circuit configuration in accordance with any of Claims 1 to 5, **characterized by** the fact that the negative pole (-) of the direct voltage supply is connected to ground - as is customary in motor vehicles.

## Revendications

1. Arrangement de circuit de commutation raccordé à une alimentation en tension continue, avec plusieurs dispositifs de commutation (S11 à S14; S21 à S24) connectables et déconnectables, reliés ensemble électriquement et présentant chacun une résistance montée en amont (R11 à R14; R21 à R24) pour l'émission de signaux de codification de tension, lesquels dispositifs sont coordonnés à un système d'évaluation électronique (AE) qui saisit leurs états de commutation respectifs par mesure du courant, lesdits dispositifs de commutation (S11 à S14; S21 à S24) étant divisés en deux groupes de dispositifs de commutation (1, 2) comprenant chacun plusieurs dispositifs de commutation (S11 à S14; S21 à S24), lesdits groupes de dispositifs de commutation (1, 2) étant reliés, par l'intermédiaires de diodes (D1 à D4), à deux raccords (A1, A2) du système d'évaluation électronique (AE) qui sont associés chacun à une valeur de signal électrique dépendant des dispositifs de commutation connectés (S11 à S14; S21 à S24) resp. des résistances y associées (R11 à R14; R21 à R24), c'est-à-dire codée et lesdits groupes de dispositifs de commutation (1, 2) étant reliés alternativement, par le système d'évaluation électronique (AE) au deux pôles (+, -) de l'alimentation en tension continue
**caractérisé en ce que**
- les groupes de dispositifs de commutation (1, 2) présentent à chacune de leurs entrées (e1, e2) et de leurs sorties (a1, a2) une diode (D1, D2, D3, D4), chacun desdits groupes de dispositifs de commutation (1, 2) étant relié à chacun des deux raccords (A1, A2) du système d'évaluation électronique (AE) par l'intermédiaire d'une diode (D1, D3 resp. D2, D4),
- chacun des deux raccords (A1, A2) du système d'évaluation électronique (AE) est relié au pôle positif (+) de l'alimentation en tension continue par l'intermédiaire d'une résistance de mesure (R1, R2),
- deux diodes (D1, 3), appartenant à l'un des groupes de dispositifs de commutation (1), disposées dans le même en sens par rapport l'une à l'autre, sont en sens inverse par rapport à deux diodes (D2, D4) de l'autre groupe de dispositifs de commutation (2) disposées elles aussi dans le même sens par rapport l'une à l'autre et
- qu'à chacun des deux groupes de dispositifs de commutation (1, 2) un indicateur lumineux de recherche (S), consistant au moins en une diode électroluminescente (LD1', LD2'; LD1", LD2") est coordonné, lequel est relié, d'une part, à un troisième raccord (A3) du système d'évaluation électronique (AE) coordonné au pôle positif (+) de l'alimentation en tension continue et, d'autre part relié aux deux raccords (A1, A2) du système d'évaluation électronique, par l'intermédiaire des deux diodes (D3, D4) qui sont coordonnées aux sorties reliées ensemble (a1, a2) des deux groupes de dispositifs de commutation (1, 2) et assurent la liaison au pôle négatif (-) de l'alimentation en tension continue.

2. Arrangement de circuit de commutation électrique selon la revendication 1, **caractérisé en ce que** le système d'évaluation électronique (AE) comprend un micro-ordinateur (µC) qui présente, pour chaque groupe de dispositifs de commutation (1; 2), une sortie de commande (Port1, Port2) et une entrée de convertisseur analogique-digital (ADW1 ; ADW2), qu'à chacune des deux sorties, par l'intermédiaire d'un arrangement de résistances (R1*, R1** ; R2*, R2**), la base d'un transistor de commutation (T1; T2) est raccordée, le collecteur dudit transistor étant relié, d'une part, par l'intermédiaire de la résistance de mesure y associée (R1 ; R2), au pôle positif (+) de l'alimentation en tension de courant continu et, d'autre part aussi bien au raccord associé (A1 ; A2) du système d'évaluation électronique (AE) qu'à l'entrée du convertisseur analogique digital (ADW1, ADW2), par l'intermédiaire d'un autre arrangement de résistances (R1', R1"; R2', R2").

3. Arrangement de circuit de commutation électrique selon la revendication 2, **caractérisé en ce que** les deux transistors de commutation (T1 ; T2) et les arrangements de résistances (R1', R1"; R2', R2"; R1*, R1**; R2*, R2**) y associés de même que les deux résistances de mesure (R1 ; R2) sont intégrés dans le micro-ordinateur (µC).

4. Arrangement de circuit de commutation électrique selon l'une des revendications 1 à 3, **caractérisé en ce que** le raccord (A3) du système d'évaluation électronique (AE), attribué au pôle positif (+) et prévu pour l'alimentation de l'indicateur lumineux de recherche (S) délivre un signal modulé par impulsions en largeur, qu'il est relié à l'alimentation en tension continue par l'intermédiaire d'un transistor PNP (T3'), dont la base est reliée, d'une part, par l'intermédiaire d'un diviseur de tension formé de deux résistances (R3', R3"), au pôle positif (+) de l'alimentation en tension et, d'autre part, au collecteur d'un transistor NPN (T3") dont l'émetteur est mis à la masse et dont la base est raccordée à son tour, par l'intermédiaire d'un arrangement de résistances (R3*, R3**), à une sortie (PWM) du micro-ordinateur (µC) qui délivre un signal modulé par impulsions en largeur.

5. Arrangement de circuit de commutation électrique selon l'une des revendications 1 à 3, **caractérisé en ce que** la clarté de l'indicateur lumineux de recherche (S) est influencée par sa durée de connexion et que ladite durée de connexion dépend de la durée de connexion des transistors (T1, T2).

6. Arrangement de circuit de commutation électrique selon l'une des revendications 1 à 5, **caractérisé en ce que** le pôle négatif (-) de l'alimentation en tension continue est mis à la masse - comme ceci est habituel dans les véhicules automobiles.
